# EUROPÄISCHE PATENTANMELDUNG

(11) **EP 2 878 965 A1**
(43) Veröffentlichungstag der Anmeldung: **03.06.2015**
(21) Anmeldenummer: 14195285.3
(22) Anmeldetag: 27.11.2014
(51) Int. Cl.: G01R 31/3187, G05B 23/00, G01R 31/00, G01R 35/00

(54) **Verfahren zur Überprüfung eines Bediengeräts für ein Fahrzeug sowie Bediengerät für ein Fahrzeug mit Diagnoseeinrichtung**

(30) Priorität: 27.11.2013 DE 102013113136
(71) Anmelder: Wachendorff Elektronik GmbH & Co. KG, 65366 Geisenheim (DE)
(72) Erfinder: Ziesen, Dirk, 65391 Lorch (DE); Wachendorff, Peter, 65391 Lorch (DE)
(74) Vertreter: Katscher Habermann Patentanwälte

(57) **Zusammenfassung**

Bei einem Verfahren zur Überprüfung eines Produkts (5), insbesondere eines Bediengeräts (5) mit einer Bediengerätanzeigeeinrichtung, mit mindestens einer elektronischen Komponente (6, 7) und mit zwei Kontakten (9, 10) in mindestens einer drahtgebundenen Schnittstelle (8) zur Signalübermittlung von und an externe Geräte wird die mindestens eine Schnittstelle (8) mit einer Diagnoseeinrichtung (15) verbunden, wobei das Prüfverfahren aus einer in dem Produkt (5) angeordneten Prüfprogramm-Speichereinrichtung (14) abgerufen und von einer in dem Produkt (5) angeordneten Mikroprozessoreinrichtung (13) ausgeführt wird. Bei einer Verbindung der Diagnoseeinrichtung (15) mit dem Produkt (5) wird automatisch das Prüfverfahren aktiviert und durchgeführt. Ein Produkt (5) und eine Diagnoseeinrichtung (15) zur Durchführung eines Prüfverfahrens sind derart ausgebildet, dass das Produkt (5) eine Prüfprogramm-Speichereinrichtung (14) mit einem darin gespeicherten Prüfprogramm und einen Mikroprozessor (13) zur Durchführung des Prüfprogramms aufweist. Die Diagnoseeinrichtung (15) weist eine elektrisch leitende Kontaktbrücke (16) zum Verbinden der mindestens zwei Kontakte (9, 10) in der mindestens einen Schnittstelle (8) des Produkts (5) auf.

## Beschreibung

Die Erfindung betrifft ein Verfahren zur Überprüfung eines Produkts mit mindestens einer elektronischen Komponente und mit zwei elektrischen Kontakten in mindestens einer drahtgebundenen Schnittstelle zur Signalübermittlung von und an externe Geräte, wobei mindestens eine Schnittstelle mit einer Diagnoseeinrichtung verbunden wird, wobei ein Prüfverfahren nach der Verbindung der Diagnoseeinrichtung mit der mindestens einen Schnittstelle des Bediengeräts aktiviert und durchgeführt wird, und wobei Prüfergebnisse an eine Anzeige- oder Speichereinrichtung übermittelt werden. Bei dem Produkt kann es sich erfindungsgemäß in vorteilhafter Weise um ein Bediengerät für ein Fahrzeug mit einer Bediengerätanzeigeeinrichtung handeln.

Bei einem Bediengerät für ein Fahrzeug mit einer elektronischen Komponente ist es oftmals erforderlich, dass das Bediengerät und insbesondere die Funktionsfähigkeit der elektronischen Komponenten des Bediengeräts überprüft und eventuelle Fehler diagnostiziert werden können. Insbesondere bei Bediengeräten für Nutzfahrzeuge, mit denen einzelne Nutzeinrichtungen des Nutzfahrzeugs gesteuert werden können, ist ein zuverlässiger Betrieb des Bediengeräts von besonderer Bedeutung, um eine fehlerfreie Verwendung des Nutzfahrzeugs ohne eine unerwünschte Gefährdung von Personen gewährleisten zu können, die das Nutzfahrzeug bedienen oder umgeben. Während der Herstellung sowie vor oder nach der Auslieferung des Bediengeräts an einen Kunden können durch den Hersteller oder einen Produktverantwortlichen Kontrollen der einzelnen Komponenten und des gesamten Bediengeräts erforderlich oder zweckmäßig sein. Zu einem späteren Zeitpunkt kann eine derartige Diagnose entweder bei einem Verdacht auf eine Fehlfunktion des Bediengeräts durchgeführt werden müssen oder im Rahmen einer Wartung oder einer Kontrolle des Bediengeräts in regelmäßigen Abständen durchgeführt werden.

Um das Bediengerät zu überprüfen wird üblicherweise eine Diagnoseeinrichtung mit dem Bediengerät verbunden und ein Prüfverfahren von der Diagnoseeinrichtung aktiviert und durchgeführt, mit dem die elektronischen Komponenten des Bediengeräts überprüft werden. Die Prüfergebnisse werden an eine Anzeige- oder Speichereinrichtung übermittelt, um angezeigt zu werden und um zum Zwecke einer späteren Kontrolle oder Weiterverarbeitung abgespeichert zu werden.

Aus der Praxis sind komplexe Diagnoseeinrichtungen bekannt, bei denen eine Anzeigeeinrichtung und eine Speichereinrichtung integriert sind. Wenn die Diagnoseeinrichtung mit der mindestens einer Schnittstelle des Bediengeräts verbunden wird, kann auf der Diagnoseeinrichtung ein Prüfverfahren aktiviert und durchgeführt werden, dass über die Schnittstelle auf die elektronischen Komponenten des Bediengeräts zugreift und eine Überprüfung dieser elektronischen Komponenten durchführt. Die Prüfergebnisse werden mit der Anzeigeeinrichtung der Diagnoseeinrichtung angezeigt und in der integrierten Speichereinrichtung zur weiteren Verwendung abgespeichert. Derartige Diagnoseeinrichtungen sind üblicherweise transportable Diagnosegeräte, die mittels geeigneter Steckverbinder mit den drahtgebundenen Schnittstellen eines Bediengeräts oder gegebenenfalls mit entsprechenden Adaptern oder Steckverbindern mit mehreren verschiedenen Bediengeräten verbunden werden können.

Aus der Praxis sind weiterhin sogenannte Diagnosestecker oder Diagnoseschnittstellen bekannt, die in Verbindung mit einem handelsüblichen Computer oder einer mobilen Rechnereinrichtung wie beispielsweise einem Laptop oder einem Tablet-PC die Diagnoseeinrichtung bilden. Nach einer Verbindung des Computers über den Diagnosestecker mit dem zu überprüfenden Bediengerät kann auf dem Computer das Prüfverfahren aktiviert und durchgeführt werden, das über die elektronischen Kontakte der drahtgebundenen Schnittstelle auf die elektronischen Komponenten des Bediengeräts zugreifen und diese überprüfen kann. Die Prüfergebnisse werden in dem Computer gespeichert und können zeitgleich oder zu einem späteren Zeitpunkt angezeigt und gegebenenfalls weiterverarbeitet werden.

Wenn das Bediengerät während und unmittelbar nach der Herstellung von dem Hersteller überprüft werden muss oder soll, stehen dem Hersteller üblicherweise komplexe und komfortable Diagnoseeinrichtungen zur Verfügung. Soll jedoch eine Überprüfung des Bediengeräts nach der Auslieferung an einen Benutzer und gegebenenfalls während des Betriebs oder in einer für den Betrieb zweckmäßigen Einbausituation erfolgen, werden üblicherweise möglichst transportable und einfach, bzw. zuverlässig bedienbare Diagnoseeinrichtungen bevorzugt.

Wenn bei einem Benutzer ein Bediengerät überprüft werden soll und die zu dem Bediengerät passende Diagnoseeinrichtung - wie üblich - dem Benutzer nicht zur Verfügung steht, muss in aller Regel ein Service-Mitarbeiter mit der für das Bediengerät geeigneten Diagnoseeinrichtung vor Ort die Überprüfung des Bediengeräts durchführen. Der hierfür erforderliche Aufwand ist vergleichsweise hoch. Zudem muss der Service-Mitarbeiter regelmäßig viele verschiedene Diagnoseeinrichtungen mit sich führen, um vor Ort unterschiedliche Bediengeräte überprüfen zu können, die von ihm betreut werden. Es ist ebenfalls möglich, dass das Bediengerät von dem Benutzer an eine zentrale Service-Stelle gebracht oder gesandt und dort mit geeigneten Diagnoseeinrichtungen überprüft wird. Der Aufwand ist für den Benutzer jedoch groß. Zudem muss der Benutzer für die Dauer des Versendens und der Überprüfung an der zentralen Service-Stelle auf das Bediengerät und dessen Nutzung verzichten.

Es wird deshalb als eine Aufgabe der vorliegenden Erfindung angesehen, ein Verfahren zur Überprüfung eines Produkts, insbesondere eines Bediengeräts mit einer Bediengerätanzeigeeinrichtung und mit mindestens einer elektronischen Komponente der eingangs genannten Gattung so auszugestalten, dass der Aufwand für die Durchführung einer Diagnose, bzw. für die Überprüfung des Produkts, bzw. Bediengeräts gering gehalten werden kann.

Diese Aufgabe wird erfindungsgemäß dadurch gelöst, dass das Prüfverfahren aus einer in dem Produkt bzw. Bediengerät angeordneten Prüfprogramm-Speichereinrichtung abgerufen und von einer in dem Produkt, bzw. Bediengerät angeordneten Mikroprozessoreinrichtung ausgeführt wird. Die Diagnoseeinrichtung dient dabei lediglich der Aktivierung des Prüfverfahrens, das in dem Bediengerät gespeichert und das nach dessen Aufruf und Aktivierung von einer in dem Bediengerät angeordneten Mikroprozessoreinrichtung ausgeführt wird. Die Diagnoseeinrichtung stellt in dieser Hinsicht ein passives Bauteil dar, das weder das Prüfprogramm noch Informationen über das für das betreffende Bediengerät geeignete oder erforderliche Prüfverfahren aufweisen muss, noch die für die Durchführung der Prüfung erforderliche Hardware beinhalten muss.

Im Folgenden wird die Erfindung vereinfachend am Beispiel des Bediengeräts mit einer Bediengerätanzeigeeinrichtung beschrieben, wobei das Bediengerät ein erfindungsgemäßes Produkt darstellt.

Da das Prüfprogramm in dem Bediengerät hinterlegt und abgespeichert ist und durch die Verbindung mit der Diagnoseeinrichtung lediglich aktiviert wird, ist eine Fehlauswahl des Diagnoseprogramms oder eine fehlerhafte Bedienung des Diagnoseprogramms während der Durchführung ausgeschlossen. Zudem kann das Prüfprogramm von dem Hersteller des Bediengeräts in dem betreffenden Produkt hinterlegt werden und muss nicht zusätzlich in externen Diagnosegeräten hinterlegt oder externen Service-Mitarbeitern zur Verfügung gestellt werden, wodurch sich die Bediengerätsicherheit erhöht und das Know-how des Bediengerätherstellers besser geheim gehalten werden kann.

Vielmehr kann die Diagnoseeinrichtung beispielsweise eine Kontaktbrücke oder einen Schalter aufweisen, mit welchem über die zwei elektrischen Kontakte der Schnittstelle zu dem Bediengerät das in dem Bediengerät hinterlegte Prüfverfahren aktiviert werden kann, um unter Verwendung der in dem Bediengerät befindlichen Hardware das Prüfverfahren durchzuführen.

Die Beschaffungs- und Montagekosten für eine Speichereinrichtung und eine Mikroprozessoreinrichtung, die gegebenenfalls zusätzlich zu den bereits vorhandenen elektronischen Komponenten in dem Bediengerät integriert sein müssen, stehen in keinem Verhältnis zu den dadurch möglichen Einsparungen an Zeitaufwand und Kosten für die Durchführung von Prüfungen des Bediengeräts, sofern diese Prüfungen nicht unmittelbar während oder nach der Herstellung durch den Hersteller selbst durchgeführt werden können. Ein mit der Überprüfung und Fehlerdiagnose des Bediengeräts beauftragter Service-Mitarbeiter muss lediglich eine geeignete passive Diagnoseeinrichtung bereit halten, die mit der drahtgebundenen Schnittstelle des Bediengeräts verbunden und zur Aktivierung des Prüfverfahrens verwendet werden kann. Eine derartige Diagnoseeinrichtung kann ein gegebenenfalls modular anpassbarer Steckverbinder sein, in dem eine elektrisch leitende Kontaktbrücke angeordnet ist, die bei einer Verbindung mit der drahtgebundenen Schnittstelle die zwei elektrisch leitenden Kontakte kurzschließt und dadurch das Prüfverfahren aktiviert.

Durch eine elektrisch leitende Verbindung der Kontakte der Schnittstelle durch die Diagnoseeinrichtung wird zudem eine Überprüfung der elektrisch leitenden Kontakte, bzw. der Schnittstelle ermöglicht. Eventuelle Beschädigungen der Schnittstelle oder Fehlfunktionen der elektrisch leitenden Kontakte der Schnittstelle können dadurch ebenfalls überprüft und erkannt werden.

Insbesondere bei komplexen Bediengeräten mit vielen elektronischen Komponenten können bereits geeignete Speichereinrichtungen und Mikroprozessoreinrichtungen bei dem Bediengerät vorgesehen sein, um die Bediengerätfunktionalität zu ermöglichen. Der zusätzlich anfallende Herstellungsaufwand, um ein Prüfprogramm in der vorhandenen Speichereinrichtung abzuspeichern und zur Durchführung auf der vorhandenen Mikroprozessoreinrichtung zu konfigurieren ist äußerst gering. Während des Ablaufs des Prüfprogramms sowie nach der Durchführung des Prüfprogramms können Informationen und Ergebnisse auf der Bediengerätanzeigeeinrichtung angezeigt werden.

Zudem kann eine derartige Diagnoseeinrichtung sehr kostengünstig zusammen mit dem Bediengerät ausgeliefert und von einem Käufer, bzw. Benutzer bedient werden, so dass es nicht grundsätzlich erforderlich ist, eine Prüfung oder eine erste Diagnose von einem Service-Mitarbeiter vor Ort durchführen zu lassen.

Vorzugsweise ist vorgesehen, dass mit einer in dem Bediengerät angeordneten Überwachungseinrichtung die Verbindung der Diagnoseeinrichtung mit dem Bediengerät festgestellt und die Aktivierung des Prüfverfahrens ermöglicht wird. Mit Hilfe einer derartigen Überwachungseinrichtung kann vorgesehen sein, dass bei einer Verbindung der Diagnoseeinrichtung mit dem Bediengerät automatisch das Prüfverfahren aktiviert und durchgeführt wird. Die Diagnoseeinrichtung, die lediglich der Aktivierung des Prüfverfahrens dient, kann konstruktiv einfach und kostengünstig ausgestaltet sein. Es ist im einfachsten Fall lediglich erforderlich, dass die Überwachungseinrichtung die Verbindung der Diagnoseeinrichtung mit der Schnittstelle des Bediengeräts feststellen kann. Elektronische Komponenten oder komplexe Schaltungseinrichtungen müssen in der Diagnoseeinrichtung nicht vorhanden sein. Die Diagnoseeinrichtung kann so ausgestaltet sein, dass sie weitestgehend oder völlig unempfindlich gegenüber den üblicherweise auftretenden mechanischen Belastungen ist und auch bei extremen Temperatur- und Umgebungsbedingungen eingesetzt werden kann.

Gemäß einer vorteilhaften Ausgestaltung des erfindungsgemäßen Verfahrens kann vorgesehen sein, dass bei der Durchführung des Prüfverfahrens eine Belastungsprüfung einer elektronischen Komponente des Bediengeräts durchgeführt wird. Durch eine Belastungsprüfung können in einigen Fällen Fehlfunktionen oder Beeinträchtigungen eines Bediengeräts festgestellt werden, die sich bei einer wenig intensiven Benutzung des Bediengeräts oder im Rahmen eines lediglich stichprobenartigen Testverfahrens nicht oder nur in Ausnahmefällen feststellen lassen.

Die Erfindung betrifft auch ein Produkt, insbesondere ein Bediengerät mit einer Bediengerätanzeigeeinrichtung, und eine Diagnoseeinrichtung zur Durchführung eines Prüfverfahrens, wobei das Produkt, bzw. Bediengerät mindestens eine elektronische Komponente und mindestens zwei elektrisch leitende Kontakte in mindestens einer drahtgebundenen Schnittstelle zur Signalübermittlung aufweist, und wobei die Diagnoseeinrichtung mit mindestens einer Schnittstelle des Produkts, bzw. des Bediengeräts verbindbar ist.

Es sind Diagnoseeinrichtungen bekannt, die beispielsweise transportable Geräte oder handelsübliche Computer in Verbindung mit einer geeigneten Prüfsoftware und einem Diagnosestecker sein können.

Erfindungsgemäß ist vorgesehen, dass das Bediengerät eine Prüfprogramm-Speichereinrichtung mit einem darin gespeicherten Prüfprogramm und einen Mikroprozessor zur Durchführung des Prüfprogramms aufweist. Das Bediengerät ist weiterhin so eingerichtet, dass die Ergebnisse des durchgeführten Prüfprogramms sowie gegebenenfalls Informationen zu einzelnen Prüfschritten oder eine Fortschrittsanzeige auf der Bediengerätanzeigeeinrichtung angezeigt werden können.

Vorzugsweise ist vorgesehen, dass die Diagnoseeinrichtung eine elektrisch leitende Kontaktbrücke zum Verbinden der mindestens zwei Kontakte in der mindestens einen Schnittstelle des Bediengeräts aufweist. Eine elektrisch leitende Kontaktbrücke lässt sich mit äußerst geringem Konstruktionsaufwand realisieren. Die Diagnoseeinrichtung kann im einfachsten Fall aus der elektrisch leitenden Kontaktbrücke bestehen, die lediglich zum Überbrücken der zwei elektrisch leitenden Kontakte kurz mit diesen Kontakten verbunden werden muss, um das Prüfprogramm in dem Bediengerät zu aktivieren und dessen Durchführung anzustoßen.

Gemäß einer besonders vorteilhaften Ausgestaltung des Erfindungsgedankens ist vorgesehen, dass die Diagnoseeinrichtung eine Anzahl von Kontaktbrücken aufweist und dass bei einer Verbindung der Diagnoseeinrichtung mit der mindestens einen Schnittstelle jeder Kontakt in der mindestens einen Schnittstelle des Bediengeräts mit einem anderen Kontakt elektrisch leitend verbunden ist. Auf diese Weise können nicht nur die in dem Bediengerät befindlichen elektronischen Komponenten, sondern auch die einzelnen elektronischen Kontakte der mindestens einen Schnittstelle überprüft werden, um sicherzustellen, dass die einzelnen Kontakte elektrisch leitend mit den elektronischen Komponenten in dem Bediengerät verbunden sind und elektrische Signale zuverlässig übertragen können. Durch das Prüfprogramm können von dem Prüfprogramm elektrische Signale an einen einzelnen elektrischen Kontakt übermittelt werden, die über eine Kontaktbrücke auf einen anderen Kontakt übertragen und dort von dem Prüfprogramm festgestellt und überprüft werden können.

Um das Prüfverfahren zuverlässiger durchführen zu können und aussagefähige Prüfergebnisse für jeden einzelnen elektrisch leitenden Kontakt erhalten zu können ist vorgesehen, dass jeder Kontakt in der mindestens einen Schnittstelle des Bediengeräts mit genau einem anderen Kontakt in einer Schnittstelle des Bediengeräts durch die Diagnoseeinrichtung elektrisch leitend verbunden ist.

Zweckmäßigerweise ist vorgesehen, dass das Bediengerät eine Überwachungseinrichtung aufweist, mit deren Hilfe feststellbar ist, ob die Diagnoseeinrichtung mit der mindestens einen Schnittstelle des Bediengeräts verbunden ist.

Gemäß einer besonders vorteilhaften Ausgestaltung des Erfindungsgedankens ist vorgesehen, dass das Bediengerät mindestens zwei elektrisch leitende Kontakte zur Verbindung mit einer Energieversorgung aufweist und dass die Diagnoseeinrichtung eine mit den elektrisch leitenden Kontakten verbundene Diagnoseschnittstelle zur Anbindung an eine Energieversorgung aufweist. Die Diagnoseeinrichtung weist zweckmäßigerweise zwei identisch übereinstimmende Diagnoseschnittstellen auf, wobei eine erste Diagnoseschnittstelle zur Verbindung mit dem Bediengerät und eine zweite Diagnoseschnittstelle zur Verbindung mit einem BUS-System oder mit einer externen Energieversorgung dienen können. Das BUS-System oder die externe Energieversorgung wären ohne die Diagnoseeinrichtung direkt mit dem Bediengerät verbunden, so dass die Diagnoseeinrichtung dazwischen angeordnet werden kann und eine externe Energieversorgung des Bediengeräts auch während der Durchführung des Prüfprogramms ermöglicht und gewährleistet wird.

Die Diagnoseeinrichtung kann auch eine Wandlereinrichtung zur datenübertragenden Anbindung der Diagnoseeinrichtung an eine Internet-Kommunikationseinrichtung aufweisen. Die Prüfergebnisse können von dem Prüfprogramm des Bediengeräts über die Wandlereinrichtung der Diagnoseeinrichtung an das Internet übermittelt und weltweit abgerufen und gespeichert oder einer Auswertung zugeführt werden.

Nachfolgend werden Ausführungsbeispiele des Erfindungsgedankens näher erläutert, die in der Zeichnung dargestellt sind.

Es zeigt:
Fig. 1 einen schematischen Verfahrensablauf zur Überprüfung eines Bediengeräts mit einer Bediengerätanzeigeeinrichtung,
Fig. 2 eine schematische Darstellung eines Bediengeräts mit einer Diagnoseeinrichtung, die mit einer drahtgebundenen Schnittstelle des Bediengeräts verbunden ist,
Fig. 3 eine ebenfalls schematische Darstellung einer abweichenden Ausgestaltung der Diagnoseeinrichtung, die zwischen eine externe Energieversorgung und das Bediengerät zwischengeschaltet ist, und
Fig. 4 eine perspektivische Abbildung des Bediengeräts mit der in Fig. 3 gezeigten Diagnoseeinrichtung.

Bei einem erfindungsgemäßen Verfahren zur Überprüfung eines Bediengeräts mit einer Bediengerätanzeigeeinrichtung und mit mindestens einer elektronischen Komponente wird in einem ersten Verfahrensschritt 1 kontinuierlich überprüft, ob eine Diagnoseeinrichtung mit einer drahtgebundenen Schnittstelle des Bediengeräts verbunden wird. Der Verfahrensschritt 1 der Überprüfung wird entweder kontinuierlich oder in zeitlichen Abständen wiederholt, bis eine Verbindung einer Diagnoseeinrichtung mit der Schnittstelle festgestellt wird. Durch die Verbindung der Diagnoseeinrichtung mit der Schnittstelle wird in einem Verfahrensschritt 2 ein Prüfprogramm aus einer Prüfprogramm-Speichereinrichtung in dem Bediengerät abgerufen und aktiviert.

In einem Verfahrensschritt 3 wird das Prüfprogramm auf einer Mikroprozessoreinrichtung in dem Bediengerät durchgeführt, um die elektronischen Komponenten und die elektrisch leitenden Kontakte der Schnittstelle sowie eventuell die Bediengerätanzeigeeinrichtung des Bediengeräts überprüfen und auf ihre Funktionsfähigkeit, bzw. auf eventuelle Fehler überprüfen zu können.

Die Ergebnisse des in dem Verfahrensschritt 3 durchgeführten Prüfungsverfahrens werden in einem entweder kontinuierlich oder in zeitlichen Abständen während des Prüfverfahrens oder im Anschluss daran durchgeführten Verfahrensschritt 4 an eine Anzeige- und Auswerteeinrichtung übermittelt.

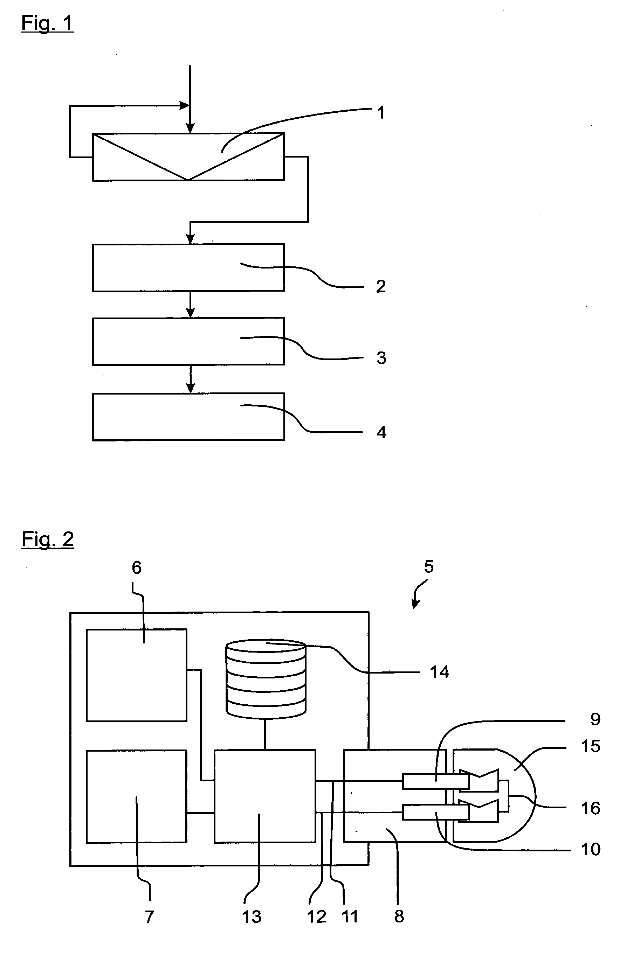

In Figur 2 ist ein Bediengerät 5 mit einer nicht dargestellten Bediengerätanzeigeeinrichtung und mit zwei elektronischen Komponenten 6 und 7 schematisch dargestellt, das eine Schnittstelle 8 mit zwei elektrisch leitenden Kontakten 9, 10 aufweist. Die elektrisch leitenden Kontakte 9, 10 sind über elektrisch leitende Leitungen 11, 12 mit einer Mikroprozessoreinrichtung 13 verbunden, die ihrerseits mit den elektronischen Komponenten 6 und 7 verbunden ist. Die Mikroprozessoreinrichtung kann eine weitere elektronische Komponente darstellen, die bereits für die Funktionsfähigkeit des Bediengeräts 5 notwendig und deshalb in dem Bediengerät 5 vorgesehen ist.

Die Mikroprozessoreinrichtung 13 ist darüber hinaus mit einer Speichereinrichtung 14 verbunden, in der ein Prüfprogramm dauerhaft gespeichert ist, das jederzeit von der Mikroprozessoreinrichtung aufgerufen und ausgeführt werden kann.

Wird wie in Figur 2 exemplarisch dargestellt die Schnittstelle 8 mit einer Diagnoseeinrichtung 15 verbunden, so dass eine in der Diagnoseeinrichtung 15 vorhandene elektrisch leitenden Kontaktbrücke 16 die beiden elektrisch leitenden Kontakte 9 und 10 miteinander verbindet, kann die dadurch hergestellte elektrisch leitende Verbindung der beiden Kontakte 9 und 10 von einer nicht näher dargestellten Überwachungseinrichtung erfasst werden und das Aufrufen und Aktivieren des Prüfprogramms in dem Bediengerät 5 veranlassen.

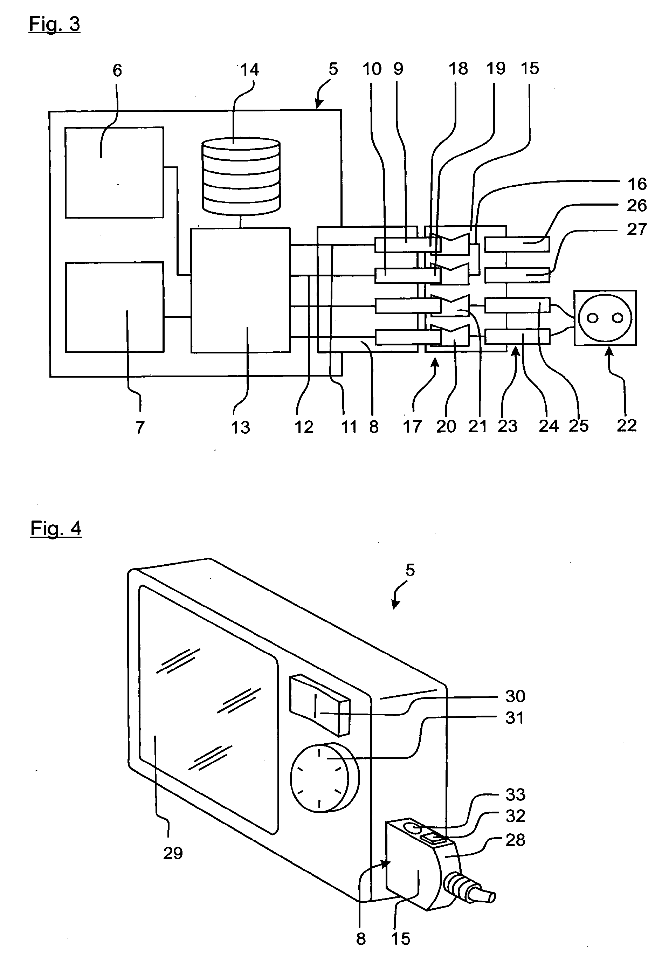

Bei einer in Fig. 3 exemplarisch dargestellten abweichenden Ausgestaltung der Diagnoseeinrichtung 15 weist die Diagnoseeinrichtung 15 eine erste Diagnoseschnittstelle 17 mit vier elektrisch leitenden Kontakten 18, 19, 20 und 21 auf. Die beiden elektrisch leitenden Kontakte 20 und 21 dienen der Verbindung des Bediengeräts 5 mit einer externen Energieversorgung 22. Bei der Diagnoseeinrichtung 15 ist eine weitere zweite Diagnoseschnittstelle 23 vorgesehen, die ebenfalls eine Verbindungseinrichtung für vier elektrisch leitende Kontakte 24, 25, 26 und 27 aufweist. Die beiden elektrisch leitenden Kontakte 24 und 25 der zweiten Diagnoseschnittstelle 23 sind elektrisch leitend mit den Kontakten 20 und 21 der ersten Diagnoseschnittstelle 17 verbunden und gewährleisten die Energieversorgung des Bediengeräts auch während eines Prüfvorgangs, bzw. mit dazwischengeschalteter Diagnoseeinrichtung 15. Die beiden elektrisch leitenden Kontakte 18, 19 der ersten Diagnoseschnittstelle 17 sind mit der elektrisch leitenden Kontaktbrücke 16 miteinander verbunden. Die beiden zugeordneten Kontakte 26 und 27 der zweiten Diagnoseschnittstelle 23 sind nicht konnektiert und nicht miteinander verbunden, können also nicht genutzt werden. Da die erste Diagnoseschnittstelle 17 und die zweite Diagnoseschnittstelle 23 als aneinander angepasste Steckverbindung ausgestaltet sind, kann die Diagnoseeinrichtung 15 beispielsweise zwischen einen BUS-Stecker und das Bediengerät 5 oder zwischen eine externe Energieversorgung und das Bediengerät 5 dazwischengeschaltet werden und einen Prüfvorgang ermöglichen, wobei gleichzeitig die Energieversorgung beibehalten wird und alle weiteren elektrisch leitenden Kontakte 9, 10 des Bediengeräts 5 getestet werden können.

In Fig. 4 ist zur Veranschaulichung eine perspektivische Darstellung des Bediengeräts 5 gezeigt, das während des vorgesehenen Betriebs in einem Fahrzeug über einen Kontaktstecker 28 mit der Fahrzeugelektronik verbunden ist. Über den Kontaktstecker 28 werden das Bediengerät 5 mit Energie versorgt und Informationen mit der Fahrzeugelektronik ausgetauscht. Auf einer Bediengerätanzeigeeinrichtung 29 können Informationen über den Zustand und Steuerungsmöglichkeiten von verschiedenen Fahrzeugkomponenten angezeigt werden. Die Bedienung des Fahrzeugs oder der einzelnen Fahrzeugkomponenten kann über Eingabeeinrichtungen des Bediengeräts 5 erfolgen. Lediglich exemplarisch sind bei dem in Fig. 4 gezeigten Bediengerät 5 ein Wippschalter 30 und ein Drehgeber 31 dargestellt.

Zu Diagnosezwecken ist die Diagnoseeinrichtung 15 zwischen das Bediengerät 5 und den Kontaktstecker 28 angeordnet, wobei die erste Diagnoseschnittstelle 17 der Diagnoseeinrichtung 15 mit der Schnittstelle 8 des Bediengeräts 5 verbunden ist und der Kontaktstecker 28 in die zweite Diagnoseschnittstelle 23 eingesteckt ist. Die Diagnoseeinrichtung 15 weist einen Schalter 32 auf, mit dem die Diagnoseeinrichtung 15 aktiviert und die Durchführung des in dem Bediengerät 5 hinterlegten Prüfprogramms gestartet werden kann. Informationen über den Fortschritt und die Ergebnisse des Prüfprogramms werden auf der Bediengerätanzeigeeinrichtung 29 angezeigt. Der aktuelle Status kann auch über eine optische Signaleinrichtung 33 an der Diagnoseeinrichtung 15 angezeigt werden, wobei die Signaleinrichtung kostengünstig beispielsweise als LED ausgestaltet ist, die gegebenenfalls in verschiedenen Farben blinken oder leuchten kann.

## Patentansprüche

1. Verfahren zur Überprüfung eines Produkts, insbesondere eines Bediengeräts (5) mit einer Bediengerätanzeigeeinrichtung (29), und mit mindestens einer elektronischen Komponente (6, 7) und mit zwei Kontakten (9, 10) in mindestens einer drahtgebundenen Schnittstelle (8) zur Signalübermittlung von und an externe Geräte, wobei mindestens eine Schnittstelle (8) mit einer Diagnoseeinrichtung (15) verbunden wird, wobei ein Prüfverfahren nach der Verbindung der Diagnoseeinrichtung (15) mit mindestens einer Schnittstelle (8) des Produkts (5) aktiviert und durchgeführt wird, und wobei Prüfergebnisse an eine Anzeige- oder Speichereinrichtung übermittelt werden, **dadurch gekennzeichnet, dass** das Prüfverfahren aus einer in dem Produkt (5) angeordneten Prüfprogramm-Speichereinrichtung (14) abgerufen und von einer in dem Produkt (5) angeordneten Mikroprozessoreinrichtung (13) ausgeführt wird.

2. Verfahren nach Anspruch 1, **dadurch gekennzeichnet, dass** mit einer in dem Produkt (5) angeordneten Überwachungseinrichtung die Verbindung der Diagnoseeinrichtung (15) mit dem Produkt (5) festgestellt und die Aktivierung des Prüfverfahrens ermöglicht wird.

3. Verfahren nach Anspruch 2, **dadurch gekennzeichnet, dass** bei einer Verbindung der Diagnoseeinrichtung (15) mit dem Produkt (5) automatisch das Prüfverfahren aktiviert und durchgeführt wird.

4. Verfahren nach einem der vorangehenden Ansprüche, **dadurch gekennzeichnet, dass** bei der Durchführung des Prüfverfahrens eine Belastungsprüfung einer elektronischen Komponente (6, 7) des Produkts (5) durchgeführt wird.

5. Produkt, insbesondere Bediengerät (5) mit einer Bediengerätanzeigeeinrichtung (29), mit einer Diagnoseeinrichtung (15) zur Durchführung eines Prüfverfahrens, wobei das Produkt (5) mindestens eine elektronische Komponente (6, 7) und mindestens zwei elektrisch leitende Kontakte(9, 10) in mindestens einer drahtgebundenen Schnittstelle (8) zur Signalübermittlung aufweist, und wobei die Diagnoseeinrichtung (15) mit mindestens einer Schnittstelle (8) des Produkts (5) verbindbar ist, **dadurch gekennzeichnet, dass** das Produkt (5) eine Prüfprogramm-Speichereinrichtung (14) mit einem darin gespeicherten Prüfprogramm und einen Mikroprozessor (13) zur Durchführung des Prüfprogramms aufweist.

6. Produkt (5) und Diagnoseeinrichtung (15) nach Anspruch 5, **dadurch gekennzeichnet, dass** die Diagnoseeinrichtung (15) mindestens eine elektrisch leitende Kontaktbrücke (16) zum Verbinden der mindestens zwei Kontakte (9, 10) in der mindestens einen Schnittstelle (8) des Produkts (5) aufweist.

7. Produkt (5) und Diagnoseeinrichtung (15) nach Anspruch 6, **dadurch gekennzeichnet, dass** die Diagnoseeinrichtung (15) eine Anzahl von Kontaktbrücken (16) aufweist und jeder Kontakt (9, 10) in der mindestens einen Schnittstelle (8) des Produkts (5) mit einem anderen Kontakt (10, 9) elektrisch leitend verbunden ist.

8. Produkt (5) und Diagnoseeinrichtung (15) nach Anspruch 7, **dadurch gekennzeichnet, dass** jeder Kontakt (9, 10) in der mindestens einen Schnittstelle (8) des Produkts (5) mit genau einem anderen Kontakt (10, 9) elektrisch leitend verbunden ist.

9. Produkt (5) und Diagnoseeinrichtung (15) nach einem der Ansprüche 5 bis 8, **dadurch gekennzeichnet, dass** das Produkt (5) eine Überwachungseinrichtung aufweist, mit deren Hilfe feststellbar ist, ob die Diagnoseeinrichtung (15) mit der mindestens einen Schnittstelle (8) des Produkts (5) verbunden ist.

10. Produkt (5) und Diagnoseeinrichtung (15) nach einem der Ansprüche 5 bis 9, **dadurch gekennzeichnet, dass** das Produkt (5) mindestens zwei elektrisch leitende Kontakte zur Verbindung mit einer Energieversorgung aufweist und dass die Diagnoseeinrichtung (15) eine mit den elektrisch leitenden Kontakten verbundene Schnittstelle zur Anbindung an eine Energieversorgung aufweist.

11. Produkt (5) und Diagnoseeinrichtung (15) nach einem der Ansprüche 5 bis 10, **dadurch gekennzeichnet, dass** die Diagnoseeinrichtung (15) eine Wandlereinrichtung zur datenübertragenden Anbindung der Diagnoseeinrichtung (15) an eine Internet-Kommunikationseinrichtung aufweist.
